**Europäisches Patentamt**

**European Patent Office**

**Office européen des brevets**

(19)

(11) Publication number : **0 323 345 B1**

(12) # EUROPEAN PATENT SPECIFICATION

(45) Date of publication of patent specification :
08.03.95 Bulletin 95/10

(51) Int. Cl.⁶ : **H01L 39/12, H01L 39/24**

(21) Application number : **88403328.3**

(22) Date of filing : **26.12.88**

(54) **A semiconductor substrate having a superconducting thin film.**

(30) Priority : **25.12.87 JP 328483/87**
**25.12.87 JP 328484/87**
**25.12.87 JP 328485/87**
**25.12.87 JP 328486/87**
**25.12.87 JP 328487/87**
**25.12.87 JP 328488/87**
**25.12.87 JP 328489/87**
**25.12.87 JP 328490/87**
**25.12.87 JP 328491/87**
**25.12.87 JP 328492/87**
**25.12.87 JP 328493/87**
**25.12.87 JP 328494/87**

(43) Date of publication of application :
**05.07.89 Bulletin 89/27**

(45) Publication of the grant of the patent :
**08.03.95 Bulletin 95/10**

(84) Designated Contracting States :
**DE FR GB NL**

(56) References cited :
**EP-A- 0 282 012**
**APPLIED PHYSICS LETTERS, vol. 51, no. 13, 28th September 1987, pages 1027-1029, American Insitute of Physics, New York, US; M. GURVITCH et al.: "Preparation and substrate reactions of superconducting Y-Ba-Cu-O films"**
**JAPANESE JOURNAL OF APPLIED PHYSICS, vol. 26, no. 9, September 1987, pages L1489-L1491, Tokyo, JP; T. AIDA et al.: "Preparation of YBa2Cu3O7-x superconducting thin films by RF-magnetron sputtering"**

(73) Proprietor : **SUMITOMO ELECTRIC INDUSTRIES LIMITED**
**No. 15, Kitahama 5-chome,**
**Higashi-ku**
**Osaka-shi, Osaka 541 (JP)**

(72) Inventor : **Itozaki, Hideo**
**Cabinet BALLOT**
**SCHMIDT**
**84, avenue Kléber**
**F-75116 Paris (FR)**
Inventor : **Harada, Keizo**
**Cabinet BALLOT**
**SCHMIDT**
**84, avenue Kléber**
**F-75116 Paris (FR)**
Inventor : **Fujimori, Naoji**
**Cabinet BALLOT**
**SCHMIDT**
**84, avenue Kléber**
**F-75116 Paris (FR)**
Inventor : **Yazu, Shuji**
**Cabinet BALLOT**
**SCHMIDT**
**84, avenue Kléber**
**F-75116 Paris (FR)**
Inventor : **Jodai, Tetsuji**
**Cabinet BALLOT**
**SCHMIDT**
**84, avenue Kléber**
**F-75116 Paris (FR)**

(74) Representative : **Ballot, Paul Denis Jacques**
**Cabinet Ballot-Schmit,**
**7, rue Le Sueur**
**F-75116 Paris (FR)**

## Description

The present invention relates to a semiconductor substrate, more particularly, it relates to a semiconductor substrate having a silicon substrate, an intermediate semiconductor layer composed of compound semiconductor material and deposited on the silicon substrate and a superconducting thin film layer composed of a compound oxide and deposited on the intermediate semiconductor layer.

The superconducting thin film layer of the semiconductor substrate according to the present invention can be used as a wiring material for semiconductor circuits which are built in the silicon substrate and/or in the intermediate semiconductor layer and for fabricating Josephson junctions for Josephson devices.

The combination of the superconducting thin film and the silicon substrate and/or the intermediate semiconductor layer according to the present invention can be used for building superconducting devices such as superconducting transistors, a hot electron transistors or the like.

Description of the related art

One of the basic technologies for fabricating an integrated circuit on a silicon single crystal substrate is a metallization technology for forming patterned conductor lines which are used for interconnecting a variety of electronic elements which are fabricated by the other basic technology including an insulating layer forming stage, a patterning stage of the insulating layer and an impurity doping stage by means of thermal diffusion, ion implantation or the like. However, a part of the signal current passing through the metallic conductor lines is lost since the cross sectional area of the metallic wiring line become very fine in the case of integrated circuits built on the silicon substrate. Therefore, it is demanded to deliver the signal current without current loss.

It is also demanded to increase the transmission velocity of signal current on the conducting lines in addition to increase the operating velocity of the active elements and passive elements themselves in order to improve the net operating velocity of the integrated circuits. However, the improvement in the transmission velocity of signal current through the conventional metallic conductor lines is limited because of the energy loss in the conducting lines. Still more, the increment in the integration degree lead to increment in power consumption owing to Joule heat which is generated in the metallic conducting lines, in other words, the degree of integration in the integrated circuit is limited. Thus, there has been strong demand to use superconductors as a material for the conductor lines.

The superconductivity is a phenomenon which is explained to be a kind of phase changes of electrons under which the electric resistance become zero and the perfect diamagnetism is observed. However, the critical temperature "Tc" of superconductivity could not exceed 23.2 K of $Nb_3Ge$ which was the highest Tc for the past ten years, so that they have not been used as a wiring material for ICs.

The possibility of an existence of a new type of superconducting material having much higher Tc was revealed by Bednorz and Müller, who discovered a new oxide type superconductor in 1986 [Z. Phys. B64 (1986) 189].

It had been known that certain ceramic materials of compound oxides exhibit the property of superconductivity. For example, U. S. patent No. 3,932,315 discloses Ba-Pb-Bi type compound oxide which shows superconductivity and Japanese patent laid-open No. 60-173,885 discloses that Ba-Bi-Pb type compound oxides also show superconductivity. These superconductors, however, possess rather lower transition temperatures of about 10 K and hence usage of liquidized helium (boiling point of 4.2 K) as cryogen is indispensable to realize superconductivity.

The new type compound oxide superconductor discovered by Bednorz and Müller is represented by [La, Sr]$_2$CuO$_4$ which is called the $K_2NiF_4$-type oxide having a crystal structure which is similar to known perovskite type oxides. The $K_2NiF_4$-type compound oxides show such higher Tc as 30 K which are extremely higher than known superconducting materials.

It was also reported that C. W. Chu et al. discovered, in the United States of America, another superconducting material so called YBCO type represented by $YBa_2Cu_3O_{7-x}$ having the critical temperature of about 90 K in February 1987. Still other type new superconducting materials which were reported recently are a compound oxide of Bi-Sr-Ca-Cu-O system and Tl-Ba-Ca-Cu-O system which exhibit such high Tc as more than 100 K and which are chemically much more stable than the abovementioned YBCO type compound oxide or the like.

And hence, the possibility of utilization of high-temperature superconductors as the wiring material for the integrated circuits.

The high-temperature superconductors are also demanded in the electronic devices. A typical application of the superconductor for the electronic devices is Josephson device in which quantum efficiency is observed macroscopically when an electric current is passed through a weak junction arranged between two superconductors. The tunnel junction type Josephson device is expected to be a high-speed and low-power consuming switching device owing to smaller energy gap of the superconducting material. It is also expected to utilize the Josephson device as a high sensitive sensor or detector for sensing very weak magnetic field, microwave, radiant ray or the like since variation of electromagnetic wave or magnetic field is reflected in variation of Josephson effect and can be observed as a precise quantum phenomenon. Development of the superconducting devices such as high-speed logic units or zero power loss wiring materials is also demanded in the field of high-speed computers in which the power consumption per unit area is reaching to the upper limit of the cooling capacity with increment of the integration density in order to reduce energy consumption.

Several ideas or concepts of new devices which are constructed by a combination of semiconductor and superconductor such as a superconducting transistor or a hot electron transistor have been proposed (M. Heiblum et al. "Solid State Electronics" Vol. 24, No. 343-346, 1981), but have not yet realized in a form of actual device.

In order to realize the above-mentioned superconducting devices such as the superconducting transistor or hot electron transistor, it is indispensable to prepare such a semiconductor substrate that has a superconducting layer which arc stratified or deposited homogeneously on a silicon substrate.

The present applicant already proposed several processes for preparing the thin films of the high-Tc superconductor on oxide substrate in the following patent applications: European patent application No. 88 400268.4, No. 88 400 598.4, No. 88 401 202.2, No. 88 401 208.9, No. 88 401 320.2 or the like.

Applied physical letters, Vol.51, N°13, 28 sept. 1987, p. 1027-1029 discloses a buffer layer of Ag and Nb interposed between a substrate and a thin film of oxide superconductor, but is silent to use a compound semiconductor as the buffer layer.

An object of the present invention is to provide a novel semiconductor substrate having a superconducting layer composed of compound oxide deposited on a silicon substrate through an intermediate semiconductor layer.

## Summary of the Invention

The present invention provides a semiconductor substrate having a silicon substrate and a superconducting thin film layer composed of compound oxide and stratified on the silicon substrate, characterized in that an intermediate semiconductor layer composed of compound semiconductor material is interposed between the silicon substrate and the superconducting thin film layer.

## Brief Description of the Drawing

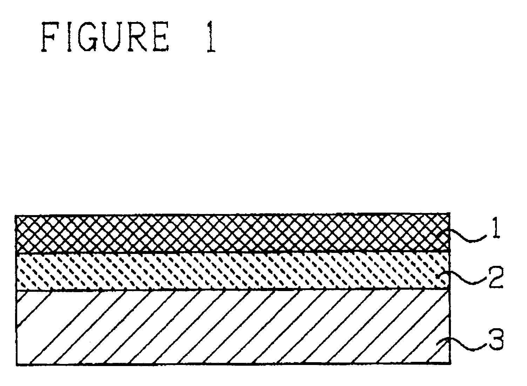

Fig. 1 shows a cross sectional view illustrating a semiconductor substrate according to the present invention.

The semiconductor substrate according to the present invention comprises a silicon substrate 3, an intermediate semiconductor layer 2 deposited on the silicon substrate 3, and a superconducting thin film layer 1 deposited on the intermediate semiconductor layer 2.

The superconducting thin film layer 1 which can be used in the present invention can be any one of compound oxide type superconducting materials.

According to a preferred embodiment of the present invention, the superconducting thin film layer is composed mainly of a compound oxide of at least one element $\alpha$ selected from IIa group of the Periodic Table, at least one element $\beta$ selected from IIIa group of the Periodic Table and at least one element $\gamma$ selected from a group comprising Ib, IIb, IIIb, IVa and VIIIa groups of the Periodic Table.

One example of this type compound oxide is represented by the general formula:

$$(\alpha_{1-x}\beta_x)\gamma_y O_z$$

in which $\alpha$, $\beta$ and $\gamma$ have the same definition as above, x is an atomic ratio of $\beta$ with respect of $(\alpha+\beta)$ and has a range of $0.1 \leq x \leq 0.9$, and y and z are respective atomic ratios with respect to $(\alpha_{1-x}\beta_x)$ which is considered to be equal to 1 and each satisfies ranges of $0.4 \leq y \leq 3.0$ and $1 \leq z \leq 5$ respectively. The element $\alpha$ of IIa group element is preferably Ba, Sr, Ca, Mg, Be or the like. More preferably the element $\alpha$ is Ba and Sr from 10 % to 80 % of which may be replaced by one or two elements selected from a group comprising Mg and Ca. The element $\beta$ of IIIa group element is preferably lanthanide such as Y, La, Sc, Ce, Gd, Ho, Er, Tm, Yb or Lu. More preferably the element $\beta$ is Y, La or Ho from 10 % to 80 % of which may be replaced by Sc or one or two elements selected from a group comprising the other lanthanide elements. The $\gamma$ is copper a part of which can be replaced by the other element selected from a group comprising Ib, IIb, IIIb, IVa and VIIIa groups of the Periodic Table such as Ti or V. Particularly, the superconducting thin film of this type compound oxide is preferably a compound oxide preferably represented by the general formula:

$$(La_{1-x}\alpha_x)_2CuO_4$$

in which $\alpha$ stands for Ba or Sr. These compound oxides are considered to be composed mainly of perovskite type or oxygen deficient perovskite type crystalline structure.

Another example of the above-mentioned compound oxide is a so called YBCO type compound oxide represented by the general formula:

$$Ln_1Ba_2Cu_3O_{7-\delta}$$

in which Ln stands for at least one lanthanide element selected from a group comprising La, Nd, Sm, Eu, Gd, Dy, Ho, Y, Er, Yb, Tm and Lu and $\delta$ is a number which satisfies a range of $0 \leqq \delta < 1$. Namely this type compound oxide are following systems:

| | | |
|---|---|---|
| $Y_1Ba_2Cu_3O_{7,\delta}$, | $Ho_1Ba_2Cu_3O_{7,\delta}$, | $Lu_1Ba_2Cu_3O_{7,\delta}$, |
| $Sm_1Ba_2Cu_3O_{7,\delta}$, | $Nd_1Ba_2Cu_3O_{7,\delta}$, | $Gd_1Ba_2Cu_3O_{7,\delta}$, |
| $Eu_1Ba_2Cu_3O_{7,\delta}$, | $Er_1Ba_2Cu_3O_{7,\delta}$, | $Dy_1Ba_2Cu_3O_{7,\delta}$, |
| $Tm_1Ba_2Cu_3O_{7,\delta}$, | $Yb_1Ba_2Cu_3O_{7,\delta}$, | $La_1Ba_2Cu_3O_{7,\delta}$ |

in which $\delta$ is a number which satisfies a range of $0 < \delta < 1$ and possess preferably perovskite type or quasi-perovskite type crystal structure. The term quasi-perovskite type means a structure which can be considered to have such a crystal structure that is similar to perovskite-type oxides and includes an orthorhombically distorted perovskite or a distorted oxygen-deficient perovskite or the like.

An atomic ratio of the lanthanide element "Ln":Ba:Cu is preferably 1 : 2: 3 as is defined by the formula but the atomic ratio is not restricted strictly to this ratio. In fact, the other compound oxides having different atomic ratios which are deviate from the above-mentioned value by 10 % may exhibit superconducting property.

Still another example of the above-mentioned compound oxide is compound oxides represented by the general formula:

$$\Theta_4(\Phi_{1-q}, Ca_q)_mCu_nO_{p+r}$$

in which $\Theta$ stands for Bi or Tl, $\Phi$ stands for Sr when $\Theta$ is Bi and stands for Ba when $\Theta$ is T1, m and n are numbers each satisfying ranges of $6 \leqq m \leqq 10$ and $4 \leqq n \leqq 8$ respectively, p = (6+m+n), q is a number which satisfies a range of $0 < q < 1$, and r is a number which satisfies a range of $-2 \leqq r \leqq + 2$. Namely, this type compound oxide include the following systems:

| | |
|---|---|
| $Bi_4Sr_4Ca_4Cu_6O_{20-r}$, | $Bi_2Sr_2Ca_2Cu_3O_{10-r}$, |
| $Tl_4Ba_4Ca_4Cu_6O_{20-r}$, | $Tl_2Ba_2Ca_2Cu_3O_{10-r}$ |

in which r is a number which satisfies a range of $-2 \leqq r \leqq + 2$.

According to the present invention, the intermediate semiconductor layer is composed of compound semiconductor material. The compound semiconductor material is preferably selected from a group comprising SiC, GaAs, GaP, InP, InSb, ZnSe, CdTe, HgCdTe, GaAlAs, GaInAs, InAlAs and InGaAsP.

Now, we will describe a process for producing the above-mentioned semiconductor substrate according to the present invention.

At first, the intermediate semiconductor layer is deposited on a silicon substrate. The deposition of the intermediate semiconductor layer can be effected by a known technique such as CVD, MBE, epitaxy technique or the like.

According to a preferred embodiment of the present invention, the semiconductor layer is deposited by the conventional chemical vapour deposition (CVD) technique on substrate.

Then, the superconducting thin film layer is deposited on the intermediate semiconductor layer by physical vapour deposition (PVD) technique such as sputtering, vacuum-deposition, molecular beam epitaxy (MBE), ion beam deposition or the like or by chemical vapour deposition (CVD) technique such as thermal CVD, plasma CVD, photo CVD, MOCVD or the like. Among the physical vapour deposition (PVD) technique, magnetron sputtering is most preferable.

The deposited thin film is preferably further heat-treated in oxygen-containing atmosphere or exposed to oxygen plasma in order to adjust the oxygen contents to a proper concentration in the crystalline structure of which the superconducting thin film is composed. In either case, the deposition of the superconducting thin film layer should be operated carefully in order not to spoil the properties of the intermediate semiconductor layer on which the superconducting thin film layer is deposited. In this sense, the substrate temperature during the deposition of the superconducting thin film should be lower than 700 °C and should not be heated to a unnecessarily high temperature during the above-mentioned after-treatment.

When electronic systems or semiconductor devices are fabricated in the silicon substrate or in the intermediate semiconductor layer according to the present invention, the superconducting thin film layer can be removed locally by etching technique or the like so that the superconducting thin film layer is shaped into a desired pattern.

The superconducting thin film layer of the semiconductor substrate according to the present invention can be used as a wiring material for semiconductor circuits which are built in the silicon substrate and/or in the intermediate semiconductor layer.

The semiconductor substrate according to the present invention can be used also as a substrate for fabricating an integrated circuit for building novel superconducting elements or a substrate on which electronic devices are built. For example, Josephson junctions can be fabricated in the superconducting thin film to built Josephson devices. The semiconductor substrate according to the present invention can be used also for fabricating high-speed semiconductor devices such as superconducting transistors having more than three electrodes, superconducting FETs or hot electron transistors which utilized the interface between the superconducting thin film layer and the semiconductor.

In conclusion, the semiconductor-superconducting composite is expected to accelerate technology for improving the operating velocity of semiconductor devices and for increasing the degree of integration.

Now, the present invention will be described with reference to examples, but the scope of the present invention should not be limited thereto.

Example 1

Two semiconductor substrate samples each having a stratified structure as is shown in Fig. 1 according to the present invention are prepared by depositing two superconducting thin film layers of Y-Ba-Cu-O system and Ho-Ba-Cu-O system on an intermediate semiconductor layer of GaAs.

At first, an intermediate semiconductor layer of GaAs having a thickness of $2,000.10^{-10}$ m (2000 Å) is deposited on a silicon substrate by the MOCVD method under the following conditions :

Source gases: TMG and $AsH_3$
Substrate temperature: 650 °C
Deposition rate: $300.10^{-10}$ m/min (300 Å/min)

Then, each of two superconducting thin films is deposited on the resulting intermediate semiconductor layer of GaAs by magnetron RF sputtering technique which is itself known. Targets used in the sputtering are sintered powder of $YBa_2Cu_{4.5}O_x$ for Y-Ba-Cu-O system and $HoBa_{2.5}Cu_{4.7}O_x$ for Ho-Ba-Cu-O system respectively. Special attention is paid to the distance between the substrate and the target and to the power of high-frequency, while the silicon substrate is heated at 700 °C during the sputtering operation so that superconducting thin film layers of the respective compound oxides are grown to $1000.10^{-10}$ m (1,000 Å).

The resulting samples of semiconductor substrates having the superconducting thin film layer show good condition at an interface between the semiconductor layer and the superconducting thin film layer. Table 1 shows the critical temperature Tco (a temperature where the phenomenon of superconductivity start to be observed) and Tci (a temperature where zero resistance is observed) of the superconducting thin films on the respective samples.

## Table 1

| Superconducting thin film | Critical temperature (K) | |
|---|---|---|
| | Tco | Tci |
| Y-Ba-Cu system | 93 | 91 |
| Ho-Ba-Cu system | 95 | 92 |

Example 2

The same operation as Example 1 is repeated except that the intermediate semiconductor layer of GaAs is replaced by SiC, GaP, InP, InSb, ZnSe, CdTe, HgCdTe, GaAlAs, GalnAs, InAlAs and InGaA6P respectively to prepare each two semiconductor substrate samples according to the present invention.

Each intermediate semiconductor layer of these compound semiconductor materials is deposited until a thickness of $2000.10^{-10}$m (2,000 Å) on the respective superconducting thin film layers by the MOCVD method by using organometals as source gases under the same condition as Example 1.

The resulting semiconductor substrates having the respective superconducting thin film layers deposited on silicon substrate through respective intermediate semiconductor layers show good conditions at the interface between the semiconductor layer and the superconducting thin film layer. Table 2 shows the critical temperature Tco and Tci of the superconducting thin films on the respective samples.

## Table 2

| Superconducting thin film | Intermediate semiconductor layer | Critical temperature Tco (K) | Tci (K) |
|---|---|---|---|
| Y-Ba-Cu system | SiC | 94 | 92 |
| | GaP | 92 | 90 |
| | InP | 95 | 92 |
| | InSb | 89 | 87 |
| | ZnSe | 91 | 88 |
| | CdTe | 90 | 87 |
| | HgCdTe | 91 | 87 |
| | GaAlAs | 87 | 85 |
| | GaInAs | 93 | 90 |
| | InAlAs | 85 | 82 |
| | InGaAsP | 90 | 85 |
| Ho-Ba-Cu system | SiC | 96 | 93 |
| | GaP | 95 | 91 |
| | InP | 97 | 94 |
| | InSb | 90 | 88 |
| | ZnSe | 93 | 90 |
| | CdTe | 88 | 85 |
| | HgCdTe | 92 | 89 |
| | GaAlAs | 89 | 86 |
| | GaInAs | 94 | 92 |
| | InAlAs | 88 | 86 |
| | InGaAsP | 91 | 88 |

## Example 3

The same operation as Example 1 is repeated except that a superconducting thin film of Bi-Sr-Ca-Cu-O system is deposited on the intermediate semiconductor layer of GaAs in place of Y-Ba-Cu-O system and Ho-Ba-Cu-O system used in Example 1 by using a target of $Bi_{1.4}Sr_1Ca_1Cu_{1.5}O_x$.

The resulting semiconductor substrate having the superconducting thin film layer of Bi-Sr-Ca-Cu-O system on the intermediate semiconductor layer of GaAs deposited on silicon substrate shows good condition at the interface between the semiconductor layer and the superconducting thin film layer. Table 3 shows the critical temperature Tco and Tci of the superconducting thin film.

## Table 3

| Substrate | Superconducting thin film | Critical temperature (K) | |
|---|---|---|---|
| | | Tco | Tci |
| MgO | Bi-Sr-Ca-Cu system | 115 | 102 |

**Claims**

1. A semiconductor-superconductor composite consisting of a silicon substrate (3) and a superconducting thin film layer of compound oxide (1) stratified on a surface of said silicon substrate, characterized in that an intermediate semiconductor layer of compound semiconductor material (2) is interposed between said surface of silicon substrate (3) and said superconducting thin film layer (1).

2. The semiconductor-superconductor composite set forth in claim 1, wherein said compound semiconductor material is selected from a group comprising SiC, GaAs, GaP, InP, InSb, ZnSe, CdTe, HgCdTe, GaAlAs, GaInAs, InAlAs and InGaAsP.

3. The semiconductor-superconductor composite set forth in claim 1 or 2, wherein said superconducting thin film layer is made of a compound oxide of at least one element $\alpha$ selected from IIa group of the Periodic Table, at least one element $\beta$ selected from IIIa group of the Periodic Table and copper.

4. The semiconductor-superconductor composite set forth in claim 3, wherein said superconducting thin film layer is made of a compound oxide represented by the general formula:
$$(\alpha_{1-x}\beta_x)Cu_yO_z$$
in which $\alpha$ and $\beta$ have the same definition as above, "x" is an atomic ratio of $\beta$ with respect to $(\alpha+\beta)$ and has a range of $0.1 \leqq x \leqq 0.9$, and y and z are respective atomic ratios with respect to $(\alpha_{1-x}\beta_x)$ which is equal to 1 and each satisfies ranges of $0.4 \leqq y \leqq 3.0$ and $1 \leqq z \leqq 5$ respectively.

5. The semiconductor-superconductor composite set forth in claim 4, wherein said compound oxide is represented by the general formula:
$$(La_{1-x}\alpha_x)_2CuO_4$$
in which $\alpha$ stands for Ba or Sr.

6. The semiconductor-superconductor composite set forth in any one of claim 3 to 5, wherein said superconducting thin film layer is made of a compound oxide having a crystal structure of perovskite or oxygen deficient perovskite.

7. The semiconductor-superconductor composite set forth in claim 3, wherein said compound oxide is represented by the general formula:
$$Ln_1Ba_2Cu_3O_{7-\delta}$$
in which "Ln" stands for at least one lanthanide element selected from a group comprising La, Nd, Sm, Eu, Gd, Dy, Ho, Y, Er, Yb, Tm and Lu and $\delta$ is a number which satisfies a range of $0 \leqq \delta < 1$.

8. The semiconductor-superconductor composite set forth in claim 7, wherein "Ln" is Y, Er, Ho or Dy.

9. The semiconductor-superconductor composite set forth in claim 7 or 8, wherein said compound oxide contains further at least one of element selected from a group comprising Al, Fe, Co, Ni, Zn, Ag and Ti.

10. The semiconductor-superconductor composite set forth in claim 3, wherein said compound oxide is represented by the general formula:

$$\Theta_4(\Phi_{1-q},Ca_q)_mCu_nO_{p+r}$$

in which $\Theta$ stands for Bi or Tl, $\Phi$ stands for Sr when $\Theta$ is Bi and stands for Ba when $\Theta$ is Tl, "m" and "n" are numbers each satisfying ranges of $6 \leqq m \leqq 10$ and $4 \leqq n \leqq 8$ respectively, $p = (6+m+n)$, q is a number which satisfies a range of $0 < q < 1$, and r is a number which satisfies a range of $-2 \leqq r \leqq +2$.

11. A process for producing a semiconductor-superconductor composite set forth in any one of claim 1 to 10, characterized in that said intermediate semiconductor layer (2) is deposited on a surface of said silicon substrate (3) by chemical vapour deposition, while said superconducting thin film layer (1) is deposited on a surface of said intermediate semiconductor layer (2) by physical vapour deposition or chemical vapour deposition.

12. The process set forth in claim 11, wherein said physical vapour deposition is sputtering.

## Patentansprüche

1. Halbleiter-Supraleiter-Zusammensetzung, bestehend aus einem Siliziumsubstrat (3) und einer supraleitenden dünnen Schicht aus Verbundoxid (1), die auf einer Oberfläche des Siliziumsubstrats aufgebracht ist, dadurch gekennzeichnet, daß eine halbleitende Zwischenschicht aus halbleitendem Verbundmaterial (2) zwischen dieser Oberfläche des Siliziumsubstrats (3) und der supraleitenden dünnen Schicht (1) angeordnet ist.

2. Halbleiter-Supraleiter-Zusammensetzung nach Anspruch 1, bei der das halbleitende Verbundmaterial ausgewählt ist aus einer Gruppe welche umfaßt SiC, GaAs, GaP, InP, InSb, ZnSe, CdTe, HgCdTe, GaAlAs, GaInAs, InAlAs und InGaAsP.

3. Halbleiter-Supraleiter-Zusammensetzung nach Anspurch 1 oder 2, bei der die supraleitende dünne Schicht aus einem Verbundoxid hergestellt ist aus wenigstens einem Element $\alpha$, ausgewählt aus der IIa-Gruppe des Periodensystems und wenigstens einem Element $\beta$, ausgewählt aus der IIIa-Gruppe des Periodensystems und Kupfer.

4. Halbleiter-Supraleiter-Zusammensetzung nach Anspruch 3, bei der die supraleitende dünne Schicht aus einem Verbundoxid hergestellt ist, das durch die allgemeine Formel dargestellt wird:

$$(\alpha_{1-x}\beta_x)Cu_yO_z$$

wobei $\alpha$ und $\beta$ wie oben definiert sind, x ein Atomverhältnis von $\beta$ bezüglich $(\alpha + \beta)$ ist und im Bereich von $0{,}1 \leqq x \leqq 0{,}9$ liegt und y und z entsprechende Atomverhältnisse bezüglich $(\alpha_{1-x}\beta_x)$ sind, welches gleich 1 ist und die die Bereiche $0{,}4 \leqq y \leqq 3{,}0$ und $1 \leqq z \leqq 5$ erfüllen.

5. Halbleiter-Supraleiter-Zusammensetzung nach Anspruch 4, bei der das Verbundoxid durch die allgemeine Formel dargestellt wird:

$$(La_{1-x}\alpha_x)_2CuO_4$$

in der $\alpha$ für Ba oder Sr steht.

6. Halbleiter-Supraleiter-Zusammensetzung nach einem der Ansprüche 3 bis 5, bei der die supraleitende dünne Schicht aus einem Verbundoxid hergestellt wird, das eine Perovskit- oder mit Sauerstoffehlstellen behaftete Perovskit-Kristallstruktur aufweist.

7. Halbleiter-Supraleiter-Zusammensetzung nach Anspruch 3, bei der das Verbundoxid durch die allgemeine Formel dargestellt wird:

$$Ln_1Ba_2Cu_3O_{7-\delta}$$

wobei "Ln" für wenigstens ein Lanthanidenelement steht, das ausgewählt ist aus einer Gruppe umfassend La, Nd, Sm, Eu, Gd, Dy, Ho, Y, Er, Yb, Tm und Lu und $\delta$ eine Zahl ist, welche den Bereich $0 \leqq \delta < 1$ erfüllt.

8. Halbleiter-Supraleiter-Zusammensetzung nach Anspruch 7, bei der "Ln" Y, Er, Ho oder Dy ist.

9. Halbleiter-Supraleiter-Zusammensetzung nach Anspruch 7 oder 8, in der das Verbundoxid ferner wenigstens ein Element aufweist, das ausgewählt ist aus der Gruppe umfassend Al, Fe, Co, Ni, Zn, Ag und Ti.

10. Halbleiter-Supraleiter-Zusammensetzung nach Anspruch 3, in der das Verbundoxid durch die allgemeine Formel dargestellt wird:

$$\Theta_4(\Phi_{1-q},Ca_q)_mCu_nO_{p+r}$$

in der $\Theta$ für Bi oder Tl steht, $\Phi$ für Sr steht, wenn $\Theta$ Bi ist und für Ba steht, wenn $\Theta$ Tl ist, m und n Zahlen sind, welche die Bereiche $6 \leqq m \leqq 10$ bzw. $4 \leqq n \leqq 8$ erfüllen, p = (6+m+n) ist, q eine Zahl ist welche den Bereich $0 < q < 1$ erfüllt und r eine Zahl ist, welche den Bereich $-2 \leqq r \leqq +2$ erfüllt.

11. Verfahren zur Herstellung einer Halbleiter-Supraleiter-Zusammensetzung nach einem der Ansprüche 1 bis 10, dadurch gekennzeichnet, daß die halbleitende Zwischenschicht (2) auf einer Oberfläche des Siliziumsubstrats (3) mittels chemischer Dampfabscheidung abgeschieden wird, während die supraleitende dünne Schicht (1) auf einer Oberfläche der halbleitenden Zwischenschicht (2) durch physikalische Dampfabscheidung oder chemische Dampfabscheidung abgeschieden wird.

12. Verfahren nach Anspruch 11, in dem die physikalische Dampfabscheidung ein Zerstäubungsverfahren ist.

**Revendications**

1. Composite supraconducteur à semi-conducteur, consistant en un substrat de silicium (3) et en une couche mince supraconductrice d'oxyde composé (1) appliquée sur une surface dudit substrat de silicium, caractérisé en ce qu'une couche semi-conductrice intermédiaire en une matière semi-conductrice composée (2) est intercalée entre ladite surface du substrat de silicium (3) et ladite couche mince supraconductrice (1).

2. Composite supraconducteur à semi-conducteur selon la revendication 1, dans lequel ladite matière semi-conductrice composée est sélectionnée à partir du groupe comprenant le SiC, le GaAs, le GaP, l'InP, l'InSb, le ZnSe, le CdTe, l'HgCdTe, le GaAlAs, le GaInAs, l'InAlAs et l'InGaAsP.

3. Composite supraconducteur à semi-conducteur selon la revendication 1 ou 2, dans lequel ladite couche mince supraconductrice est faite d'un oxyde composé d'au moins un élément $\alpha$ sélectionné à partir du groupe IIa du tableau périodique, d'au moins un élément $\beta$ sélectionné à partir du groupe IIIa du tableau périodique, et de cuivre.

4. Composite supraconducteur à semi-conducteur selon la revendication 3, dans lequel ladite couche mince supraconductrice est faite d'un oxyde composé représenté par la formule générale :

$$(\alpha_{1-x}\beta_x)\,Cu_yO_z$$

dans laquelle $\alpha$ et $\beta$ ont la même définition que ci-dessus, "x" est un rapport atomique de $\beta$ en ce qui concerne $(\alpha+\beta)$ et a une fourchette de $0,1 \leqq x \leqq 0,9$, et y et z sont des rapports atomiques respectifs en ce qui concerne $(\alpha_{1-x}\beta_x)$, égal à 1, et qui satisfont chacun à des fourchettes respectives de $0,4 \leqq y \leqq 3,0$ et $1 \leqq z \leqq 5$.

5. Composite supraconducteur à semi-conducteur selon la revendication 4, dans lequel ledit oxyde composé est représenté par la formule générale :

$$(La_{1-x}\alpha_x)_2\,CuO_4$$

dans laquelle $\alpha$ représente le Ba ou le Sr.

6. Composite supraconducteur à semi-conducteur selon l'une quelconque des revendications 3 à 5, dans lequel ladite couche mince supraconductrice est faite d'un oxyde composé ayant une structure cristalline de pérovskite ou de pérovskite à déficit d'oxygène.

7. Composite supraconducteur à semi-conducteur selon la revendication 3, dans lequel ledit oxyde composé est représenté par la formule générale :

$$Ln_1Ba_2Cu_3O_{7-\delta}$$

dans laquelle "Ln" représente au moins un élément des terres rares, sélectionné parmi un groupe comprenant le La, le Nd, le Sm, l'Eu, le Gd, le Dy, l'Ho, l'Y, l'Er, l'Yb, le Tm et le Lu, et $\delta$ est un nombre qui satisfait à une fourchette de $0 \leqq \delta < 1$.

8. Composite supraconducteur à semi-conducteur selon la revendication 7, dans lequel "Ln" est l'Y, l'Er, l'Ho ou le Dy.

9. Composite supraconducteur à semi-conducteur selon la revendication 7 ou 8, dans lequel ledit oxyde composé contient en outre au moins un élément sélectionné parmi un groupe comprenant l'Al, le Fe, le Co, le Ni, le Zn, l'Ag et le Ti.

10. Composite supraconducteur à semi-conducteur selon la revendication 3, dans lequel ledit oxyde composé est représenté par la formule générale :

$$\Theta_4(\Phi_{1-q}, Ca_q)_m Cu_n O_{p+r}$$

dans laquelle $\Theta$ représente le Bi ou le Tl, $\Phi$ représente le Sr lorsque $\Theta$ est le Bi et représente le Ba lorsque $\Theta$ est le Tl, "m" et "n" sont des nombres satisfaisant chacun à des fourchettes respectives de $6 \leqq m \leqq 10$ et $4 \leqq n \leqq 8$, p = (6+m+n), q est un nombre qui satisfait à une fourchette de 0 < q < 1, et r est un nombre qui satisfait à une fourchette de $-2 \leqq r \leqq +2$.

11. Procédé de production d'un composite supraconducteur à semi-conducteur selon l'une quelconque des revendications 1 à 10, caractérisé en ce que ladite couche semi-conductrice intermédiaire (2) est déposée sur une surface dudit substrat de silicium (3) par dépôt chimique en phase vapeur tandis que ladite couche mince supraconductrice (1) est déposée sur une surface de ladite couche semi-conductrice intermédiaire (2) par dépôt physique en phase vapeur ou par dépôt chimique en phase vapeur.

12. Procédé selon la revendication 11, dans lequel ledit dépôt physique en phase vapeur est la pulvérisation cathodique.

FIGURE 1